# EUROPÄISCHE PATENTSCHRIFT

(11) **EP 2 465 965 B1**
(45) Veröffentlichungstag und Bekanntmachung des Hinweises auf die Patenterteilung: **04.06.2014**
(21) Anmeldenummer: 11191867.8
(22) Anmeldetag: 05.12.2011
(51) Int. Cl.: C23C 4/12, B05B 7/22, H05H 1/42, H05K 3/10, H05K 3/14

(54) **Vorrichtung sowie Verfahren zum Aufspritzen einer Struktur aus leitfähigem Material auf ein Substrat**
Device and method for spraying a structure made of conductive material on a substrate
Dispositif et procédé de vaporisation d'une structure en matériau conducteur sur un substrat

(30) Priorität: 15.12.2010 DE 202010016599 U
(43) Veröffentlichungstag der Anmeldung: 20.06.2012
(73) Patentinhaber: LEONI Bordnetz-Systeme GmbH, 97318 Kizingen (DE)
(72) Erfinder: Stallwitz, Markus, 91126 Rednitzhembach (DE); Geist, Dieter, 91301 Kitzingen (DE)
(74) Vertreter: FDST Patentanwälte

(56) Entgegenhaltungen:
- EP-A1- 0 423 370
- EP-A2- 0 231 153
- EP-A2- 0 234 848
- EP-A2- 0 949 036
- EP-B1- 0 246 828
- WO-A1-2005/031026
- WO-A2-2009/088934
- DE-A1- 1 815 386
- DE-A1- 2 155 217
- DE-A1-102006 044 906
- DE-A1-102006 059 900
- JP-A- 63 206 459
- SU-A1- 656 669
- US-A- 3 016 447
- US-A- 4 142 090
- US-A- 5 298 714
- US-A1- 2003 049 384

## Beschreibung

Die Erfindung betrifft eine Vorrichtung zum Aufspritzen einer Struktur aus leitfähigem Material auf ein Substrat oder ein Bauteil mit Hilfe eines Plasmaverfahrens mit den Merkmalen des Oberbegriffs des Anspruchs 1. Die Erfindung betrifft weiterhin ein Verfahren zum Aufspritzen einer Struktur aus leitfähigem Material auf ein Substrat oder ein Bauteil mit Hilfe eines Plasmaverfahrens mit den Merkmalen des Oberbegriffs des Anspruchs 15.

Bei jenem Plasmaverfahren, auch Plasmaspritzen genannt, handelt es sich um ein Oberflächenbeschichtungsverfahren, bei dem die Oberfläche des zu behandelnden Substrats oder Bauteils einer vergleichsweise geringen thermischen Belastung ausgesetzt ist. Daher eignet sich dieses Verfahren zur Oberflächenbehandlung von Substraten bzw. Bauteilen aus unterschiedlichsten Materialien. Neben der Möglichkeit, Substrate bzw. Bauteile großflächig zu beschichten, um deren Oberflächeneigenschaften gezielt zu beeinflussen, kann ein solches Verfahren auch zur Erzeugung von elektrotechnisch nutzbaren Strukturen, wie beispielsweise Leiterbahnen, eingesetzt werden.

Aus der auf die Anmelderin zurückgehenden Offenlegungsschrift DE 10 2006 061 435 A1 ist eine Vorrichtung bekannt, mit der ein entsprechendes Verfahren realisierbar ist. Hierfür wird in einer Spritzlanze ein Plasma mit einer Temperatur kleiner 3000 K erzeugt. Gleichzeitig wird mit Hilfe eines Trägergasstroms ein Pulver in die Spritzlanze eingebracht, welches vom Plasma in Richtung einer stirnseitigen Austrittsöffnung an der Spritzlanze mitgeführt wird, dort austritt und anschließend auf ein Substrat auftrifft.

Ähnliche Vorrichtungen zur Beschichtung von Oberflächen sind darüber hinaus aus den Druckschriften WO 2009/088934 A2, DE 21 55 217 A1, JP 63 206459 A, DE 18 15 386 A1, US 4 142 090 A, EP 0 246 828 B1, EP 0 234 848 A2, US 2003/049384 A1, EP 0 949 036 A2, DE 10 2006 059900 A!, WO 2005/031026 A1, DE 10 2006 044906 A1, US 3 016 447 A, US 5 298 714 A, EP 0 231 153 A2, SU 656 669 A1 sowie EP 0 423 370 A1 zu entnehmen.

Ausgehend hiervon liegt der Erfindung die Aufgabe zugrunde, eine weiter verbesserte Vorrichtung sowie Verfahren zu entwickeln.

Diese Aufgabe wird erfindungsgemäß durch eine Vorrichtung mit den Merkmalen des Anspruchs 1 sowie mit einem Verfahren gemäß Anspruch 12 gelöst. Die rückbezogenen Ansprüche beinhalten teilweise vorteilhafte und teilweise für sich selbst erfinderische Weiterbildungen dieser Erfindung. Die im Hinblick auf die Vorrichtung angeführten Ausgestaltungen lassen sich sinngemäß auch auf das Verfahren übertragen.

Die erfindungsgemäße Vorrichtung dient zum Aufspritzen einer Struktur aus leitfähigem Material, insbesondere von Leiterbahnen, auf ein Substrat oder ein Bauteil. Sie umfasst als Baugruppe einen Düsenkopf, der seinerseits eine Düsenblende, eine innere und eine äußere Elektrode aufweist. In die äußere Elektrode ist vorzugsweise zentral ein Strömungskanal mit einer endseitigen Austrittsöffnung zur Aufnahme der inneren Elektrode eingearbeitet. Ein Freiende dieser inneren Elektrode, die Austrittsöffnung des Strömungskanals und die Düsenblende bilden zusammen den Düsenaustritt des Düsenkopfes, vor dem im Betrieb ein Substrat bzw. ein Bauteil in geeignetem Abstand positioniert wird. Die Vorrichtung umfasst weiter eine Zuführung für das leitfähige Material und für ein Trägergas, über welche das leitfähige Material und das Trägergas in den Strömungskanal eingebracht werden. Bestandteil der Vorrichtung ist außerdem eine Steuerungseinheit. Diese ist derart ausgebildet, dass im Betrieb zwischen den beiden Elektroden eine elektrische Spannung anliegt, aufgrund derer das den Strömungskanal in Strömungsrichtung durchströmende Trägergas ionisiert wird, so dass sich das leitfähige Material, welches vorzugsweise als Pulver vom Trägergas mitgeführt wird, zumindest teilweise verflüssigt. Das Gemisch aus ionisiertem Trägergas und teilweise verflüssigtem leitfähigen Material wird sodann als Materialstrom aus dem Düsenaus tritt ausgestoßen und trifft in der Folge auf das Substrat bzw. auf das Bauteil auf. Hier haftet das leitfähige Material schließlich entsprechend der Zielsetzung an.

Zur weiteren Manipulation des Materialstroms ist im Bereich des Düsenaustritts eine zusätzliche Zuführung für ein Fokussiergas vorgesehen. Mit dem Fokussiergas wird der Materialstrom im Betrieb umfangseitig angeströmt, so dass der Materialstrom im weiteren Verlauf vom Fokussiergas im Wesentlichen ringförmig ummantelt ist. Dadurch kann beispielsweise der Querschnitt des Strahls aus ausgestoßenem leitfähigem Material beeinflusst werden. Gleichzeitig bewirkt das so gelenkte Fokussiergas eine lokale Kühlung der Oberfläche des vorgelagerten Substrates bzw. Bauteils, wodurch die lokale thermische Belastung der Oberfläche während des Aufspritzens verringert wird. Zudem sind weitere zusätzliche Zuführungen für das Fokussiergas vorgesehen, so dass in der Summe mehrere, beispielsweise nach Art einer Gleichteilung, über den Umfang verteilt angeordnete Zuführungen gegeben sind.

Untersuchungen haben gezeigt, dass sich im Betrieb - auch ohne Zuführung von Material, sondern lediglich bei Durchströmung des Trägergases - zwischen den beiden Elektroden ein Entladungsbogen ausbildet, der sich aufgrund der Strömung des Trägergases über die Austrittsöffnung und auch über die Düsenblende hinaus erstreckt. D.h. der Lichtbogen ist in etwa U-förmig ausgebildet, wobei der Bogen des U's außerhalb des Düsenkopfes liegt und beispielsweise im Bereich von 1 bis 3 cm von der Düsenblende beabstandet ist. Im normalen Betrieb ohne Fokussiergas zeigt sich im Außenraum außerhalb des Düsenkopfs, also vorgelagert zur Düsenblende, eine deutliche Auffächerung dieser Entladungsbögen mit einer deutlichen Ausfransung an den Rändern. Die grundsätzliche Wirkungsweise der hier beschriebenen Vorrichtung mit dem Fokussiergas ist nunmehr derart, dass durch das Fokussiergas auf das ionisierte Trägergas eingewirkt wird, derart, dass eine Fokussierung der Entladungsbögen erfolgt. Da sich im Betrieb mit einem zugeführten Material die einzelnen Partikel entlang der Entladungsbögen orientieren, erfolgt dadurch zugleich im Betrieb auch eine Fokussierung des Materialstromes.

Insgesamt ist dadurch in einfacher und effektiver Weise eine Einstellung des Strahldurchmessers auf einen gewünschten Wert mit Hilfe einer geeigneten Ansteuerung durch das Fokussiergas ermöglicht. Je nach Steuerparameter, wie beispielsweise Druck des Fokussiergases oder der Strömungsgeschwindingkeit des Fokussiergases, sowie Druck und Strömungsgeschwindigkeit des Trägergases, lässt sich der Strahldurchmesser in weiten Bereichen einstellen. Insbesondere werden Strukturen von kleiner 1 mm bis zu einigen wenigen 100 µm erzeugt. Dadurch, dass durch das Fokussiergas das Ausfransen an den Strahlrändern deutlich reduziert ist, wird zudem eine sehr gute scharf abgegrenzte Materialauftragung erzielt. Eine so genannte Kantenschärfe von erzeugten Leiterbahnen ist dabei insbesondere unter 5% bezogen auf die gesamte Bahnbreite.

Einer bevorzugten Ausgestaltung entsprechend weist der Düsenkopf eine trichterförmige Kappe oder Hülse auf, in die die äußere Elektrode mittig hineinragt. Zwischen der Kappe und der äußeren Elektrode verbleibt dabei im Montageendzustand ein Zwischenraum mit ringförmigem Querschnitt, in den die Zuführungen für das Fokussiergas münden. Durch diesen Zwischenraum strömt im Betrieb das Fokussiergas, wodurch dieses in gewünschter Weise auf den Materialstrom gelenkt wird. Eine Ausführung des Düsenkopfes mit separat gefertigter Kappe erweist sich hierbei als sehr zweckmäßig. Prinzipiell wäre es aber auch denkbar, einen entsprechenden Zwischenraum in einen einteiligen Düsenkopf einzuarbeiten.

In einer zweckmäßigen Weiterbildung ist der Zwischenraum senkrecht zur Strömungsrichtung durch die Mantelflächen zweier gerader Kreiskegelstümpfe mit unterschiedlichen Volumina begrenzt. Die Kreiskegelstumpfe weisen dabei bevorzugt einen gleich großen Öffnungswinkel auf. Zudem sind deren Basiskreise konzentrisch angeordnet. Damit ist eine sehr einfache aber dennoch in Bezug auf die lenkende Wirkung sehr effektive Geometrie für den Zwischenraum gegeben.

Bevorzugt ist zwischen den Zuführungen für das Fokussiergas und dem Zwischenraum eine ringförmige Verteilernut positioniert. Hierdurch kommt es zu nächst zu einer umfangsseitigen Verteilung des Fokussiergases, bevor dieses dann in den Zwischenraum strömt. In Konsequenz erfolgen schließlich auch die umfangseitige Anströmung und die Umhüllung des Materialstroms deutlich gleichmäßiger.

Darüber hinaus werden in vorteilhafter Gestaltung des Düsenkopfes weitere geometrische Merkmale verwirklicht. Zum Beispiel ist es günstig, wenn, bezogen auf die Strömungsrichtung, die Austrittsöffnung der Düsenblende und/oder das Freiende der inneren Elektrode der Austrittsöffnung und/oder die Verteilernut dem Freiende der inneren Elektrode vorgelagert ist.

Gemäß einer Weiterbildung der erfindungsgemäßen Vorrichtung ist im Bereich des Düsenaustritts eine weitere Zuführung für ein zweites Fokussiergas angedacht, wobei der Gasstrahl des ersten Fokussiergases im Betrieb umfangseitig mit dem zweiten Fokussiergas angeströmt wird, so dass das zweite Fokussiergas das erste Fokussiergas im weiteren Verlauf im Wesentlichen ringförmig ummantelt. Hierbei kann das zweite Fokussiergas beispielsweise als Schutzbarriere gegen die Atmosphäre genutzt werden, um Oxidationsreaktionen zu unterbinden. Es ist aber auch möglich, das zweite Fokussiergas zur Manipulation des Materialstroms nach Art der Manipulation durch das erste Fokussiergas vorzusehen. In dem Fall kann für beide Zuführungen dasselbe Gas und in Folge dessen die gleiche Quelle verwendet werden.

Dient das zweite Fokussiergas zur Manipulation des Materialstroms nach Art der Manipulation durch das erste Fokussiergas, so ist es vorteilhaft, auch dieses Fokussiergas mit Hilfe einer geeigneten Hohlraumgeometrie in Richtung zum Materialstrom zu lenken. Der entsprechende Hohlraum kann, sofern der Düsenkopf einteilig ausgestaltet ist, in den Düsenkopf eingearbeitet sein oder alternativ in die Kappe. Fertigungstechnisch einfacher ist es jedoch, eine zweite trichterförmige Kappe vorzusehen, in die die erste Kappe mittig hineinragt. Im Montageendzustand verbleibt dann wiederum ein Zwischenraum mit ringförmigem Querschnitt, in den die Zuführung für das zweite Fokussiergas mündet. Durch diesen zweiten Zwischenraum strömt, analog zum Fall des ersten Fokussiergases, im Betrieb das zweite Fokussiergas, wodurch dieses in gewünschter Weise auf den Materialstrom gelenkt wird. Vorzugsweise wird auch der zweite Zwischenraum senkrecht zur Strömungsrichtung durch die Mantelflächen zweier gerader Kreiskegelstümpfe mit unterschiedlichen Volumina begrenzt, wobei deren Basiskreise konzentrisch angeordnet sind. Die Kreiskegelstumpfe weisen dabei wiederum einen gleich großen Öffnungswinkel auf, der sich allerdings vom Öffnungswinkel des ersten Zwischenraumes unterscheiden kann.

Bevorzugt wird weiter eine Ausführung, bei der das leitfähige Material als Pulver mit dem Trägergas in den Strömungskanal eingebracht wird und dabei auf ein Umlenkelement trifft, so dass das Gemisch aus Trägergas und leitfähigem Material eine sprunghafte Richtungsänderung erfährt. Hierdurch treten, begrenzt auf den Bereich um das Umlenkelement, im Gemisch Verwirbelungen auf, die eine erneute Durchmischung und letztlich eine Homogenisierung des Gemisches zur Folge haben.

Bestandteil der erfindungsgemäßen Vorrichtung ist die zuvor erwähnte Steuerungseinheit. Dabei ist diese Steuerungseinheit derart ausgebildet, dass neben der elektrischen Spannung zwischen den Elektroden auch die Einleitung des Fokussiergases in eine jede zusätzliche Zuführung reguliert werden kann. Vorzugsweise wird durch die Regulierung der Materialstrom und insbesondere der Strahlquerschnitt des ausgestoßenen leitfähigen Materials eingestellt. Der Strahlquerschnitt, der typischerweise eine Kreisform aufweist, kann dadurch umgeformt werden, so dass als Querschnitt zum Beispiel eine ovale oder nahezu rechteckige Form gegeben ist. Es ist aber auch möglich, den Radius, oder allgemeiner die radiale Ausdehnung, des Strahlquerschnittes zu variieren. Hierfür muss bei Vorrichtungen nach dem bisherigen Stand der Technik der Düsenkopf ausgetauscht werden.

Auf jeden Fall aber ist es vorgesehen, dass mit Hilfe der Steuerungseinheit der Volumenstrom des Fokussiergases durch eine jede zusätzliche Zuführung einstellbar ist. Dabei können die Volumenströme im Betrieb auch unabhängig voneinander und proportional zu einer zeitabhängigen Funktion variiert werden. Es ist in diesem Zusammenhang angedacht, für die Steuerung aller Volumenströme eine periodische Funktion zugrunde zu legen und gleichzeitig für die Steuerung eines jeden Volumenstroms eine konstante Phase vorzugesehen, so dass der ausgestoßene Materialstrom als Folge im Wesentlichen eine Art Rotationsbewegung um die Mittellängsachse des Strömungskanals ausführt. Ohne diese Rotationsbewegung und ohne eine Bewegung des Düsenkopfes relativ zum Substrat bzw. zum Bauteil bildet sich beim Betrieb der Vorrichtung auf der Oberfläche des Substrates bzw. des Bauteiles ein ansatzweise scheibenförmiges Spritzmuster aus. Das Schichtdickenprofil dieser scheibenförmigen Materialanlagerung kann dabei näherungsweise durch eine Glockenkurve beschrieben werden. Durch die Rotationsbewegung werden quasi mehrere leicht versetzte Glockenkurven überlagert, so dass sich dabei ein eher rechteckiger Schichtdickenverlauf ausbildet. Die Strukturen aus leitfähigem Material, die mit der erfindungsgemäßen Vorrichtung aufgespritzt werden, sind bei Ausnutzung der Rotationsbewegung somit wesentlich gleichmäßiger bezüglich ihrer Schichtdicken und schärfer bezüglich ihrer Abgrenzungen in den Randbereichen.

Ausführungsbeispiele der Erfindung werden nachfolgend anhand der Figuren beschrieben. Es zeigen:
- Fig. 1: in einer Seitenansicht einen erfindungsgemäßen Düsenkopf,
- Fig. 2: den Längsschnitt II-II in Fig. 1 des erfindungsgemäßen Düsenkopfes,
- Fig. 3: in einer Seitenansicht einen alternativen erfindungsgemäßen Düsenkopf,
- Fig. 4: den Längsschnitt IV-IV in Fig. 3 des alternativen erfindungsgemäßen Düsenkopfes,
- Fig. 5: eine schematische Darstellung eines erfindungsgemäßen Düsenkopfes mitsamt einer erfindungsgemäßen Steuerungseinheit,
- Fig. 6: ein Umlenkelement im Bereich einer Zuführung eines erfindungsgemäßen Düsenkopfes,
- Fig. 7: ein Diagramm zur Darstellung einer möglichen zeitabhängigen Kombination von Fokussiergasströmen in mehrere zusätzliche Zuführungen zum Zeitpunkt 1,
- Fig. 8: ein Diagramm zur Darstellung einer möglichen zeitabhängigen Kombination von Fokussiergasströmen in mehrere zusätzliche Zuführungen zum Zeitpunkt 2,
- Fig. 9: ein Diagramm zur Darstellung einer möglichen zeitabhängigen Kombination von Fokussiergasströmen in mehrere zusätzliche Zuführungen zum Zeitpunkt 3,
- Fig. 10: eine Näherungsfunktion für das Profil einer ortsabhängigen Schichtdicke einer aufgespritzten Struktur ohne Rotation des Materialstroms,
- Fig. 11: eine Näherungsfunktion für das Profil einer ortsabhängigen Schichtdicke einer aufgespritzten Struktur bei Rotation des Materialstroms,
- Fig. 12: eine Näherungsfunktion für das Profil einer ortsabhängigen Schichtdicke einer aufgespritzten Struktur bei Rotation des Materialstroms und zusätzlicher Variation des Radius der Rotationsbewegung.

Einander entsprechende Teile sind in allen Figuren mit den gleichen Bezugszeichen versehen.

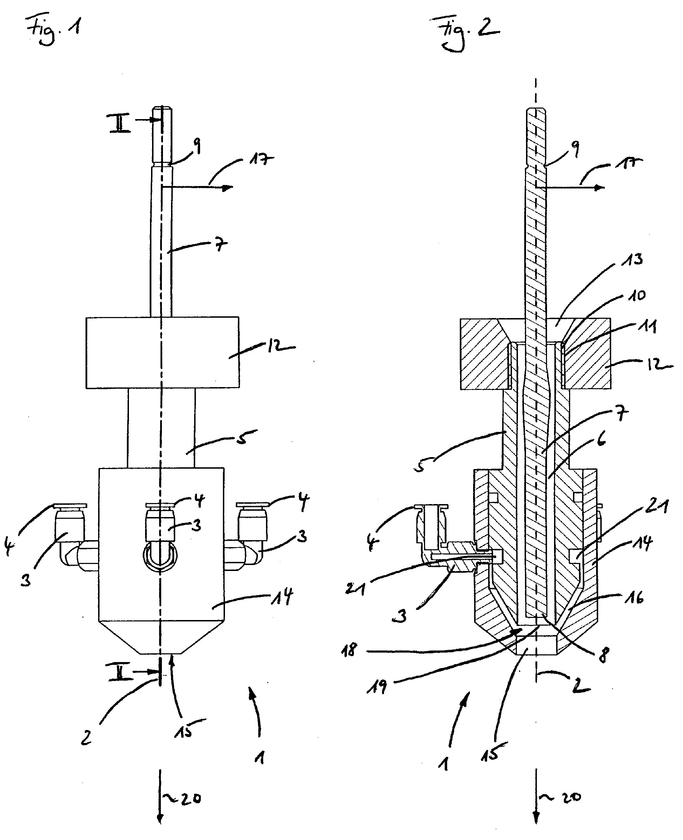

Ein erfindungsgemäßer Düsenkopf 1 ist in Fig. 1 in einer Seitenansicht dargestellt. Dieser ist in erster Näherung rotationssymmetrisch und in guter Näherung drehsymmetrisch zur Mittellängsachse 2, wobei die Drehsymmetrie aufgrund von drei nach Art einer Gleichteilung angeordneten Zuführungen 3 für ein Fokussiergas dreizählig ist. Diese Zuführungen 3 sind als winkelförmige Stutzen mit endseitigen Anschluss flansch 4 ausgestaltet und ragen radial aus dem Düsenkopf 1 heraus.

In der Schnittdarstellung aus Fig. 2 entlang der Mittellängsachse 2 ist der prinzipielle Aufbau des Düsenkopfes 1 erkennbar. Als Basisbauteil kann hierbei eine äußere Elektrode 5 angesehen werden, deren Körper im Wesentlichen durch drei geometrische Formen beschreibbar ist. Dies sind ein kleinerer Zylinder, ein größerer Zylinder und der Stumpf eines geraden Kreiskegels. Alle drei sind rotationssymmetrisch um die Mittellängsachse 2 angeordnet, wobei der größere Zylinder von den beiden anderen Formen eingerahmt wird. Mittig in die äußere Elektrode 5 ist ein zylinderförmiger Strömungskanal 6 eingearbeitet, in welchem eine stabartige und näherungsweise ebenfalls zylinderförmige innere Elektrode 7 platziert ist. Ein Ende der inneren Elektrode, das Freiende 8, liegt dabei innerhalb des Strömungskanals 6 und auf der Höhe des kegelstumpfförmigen Bereichs der äußeren Elektrode 5. Das gegenüberliegende Ende der inneren Elektrode 7 ragt aus dem Strömungskanal 6 heraus und ist mit einer Positioniernut 9 versehen. Dieses Ende wird im Rahmen der Montage des Düsenkopfes 1 an einer Haltevorrichtung, bei der es sich beispielsweise um einen steuerbaren Industrie-Roboter-Arm handelt, in ein Futter eingespannt. Zur Befestigung des gesamten Düsenkopfes 1 an der Haltevorrichtung ist darüber hinaus an der äußeren Elektrode 5 endseitig ein Gewinde 10 vorgesehen, welches bei der Montage in ein entsprechendes Gegengewinde 11 an der Haltevorrichtung, die hier durch eine Aufnahme 12 angedeutet ist, geschraubt wird.

Jene Aufnahme 12 weist eine zentral angeordnete und trichterförmige Materialaussparung 13 auf. Diese ist Teil einer nicht vollständig abgebildeten Zuführung für ein Gemisch aus einem leitfähigen, pulverförmigen Material und einem Trägergas, über welche das Gemisch in den Strömungskanal 6 eingebracht wird. Die Details einer Ausführungsvariante einer derartigen Zuführung sowie eine Vorrichtung zur Herstellung des Gemisches sind in der auf die Anmelderin zurückgehenden Offenlegungsschrift DE 10 2006 061 435 A1 beschrieben. Auf die gesamte Offenbarung in dieser Offenlegungsschrift wird ausdrücklich Bezug genommen.

Über das dem Gewinde 10 gegenüberliegende Ende der äußeren Elektrode 5 ist eine Kappe 14 mit einer eingearbeiteten scheibenförmigen Düsenblende 15 gestülpt. Zwischen der Kappe 14 und der äußeren Elektrode 5, beschränkt auf einen sich in Richtung der Mittellängsachse 2 erstreckenden Teilabschnitt der Kappe 14, verbleibt dabei ein im Querschnitt ringförmiger erster Zwischenraum, nachfolgend als Hohlraum 16 bezeichnet. In radialer Richtung 17 wird dieser Hohlraum 16 durch die Mantelflächen zweier gerader Kreiskegelstümpfe mit unterschiedlichen Volumina begrenzt. Die Kreiskegelstümpfe weisen dabei einen gleich großen Öffnungswinkel auf und deren Basiskreise sind konzentrisch angeordnet. Ein symmetrisch um die Mittellängsachse 2 positionierter, scheibenförmiger Teilbereich des Hohlraums 16, welcher nachfolgend auch als Fokussierkammer 18 bezeichnet wird, bildet zusammen mit dem Freiende 8 der inneren Elektrode 7, einer Austrittsöffnung 19 am Strömungskanal 6 und der Blende 15 den Düsenaustritt des Düsenkopfes 1. Vor diesem ist im Betrieb ein Substrat bzw. ein Bauteil, auf welches eine Struktur aufgespritzt werden soll, in geeignetem Abstand positioniert.

Im Betriebszustand strömt das über die Materialaussparung 13 eingeleitete Gemisch in Strömungsrichtung 20 durch den Strömungskanal 6, wobei das Trägergas aufgrund einer zwischen den Elektroden 5,7 anliegenden Spannung ionisiert wird. Dieser Materialstrom aus ionisiertem Trägergas und leitfähigem Material tritt dann als Strahl aus dem Düsenaustritt aus und trifft schließlich auf das Substrat bzw. das Bauteil auf. Zur Manipulation des Gemischstrahls wird das über die zusätzlichen Zuführungen 3 in den Düsenkopf 1 eingebrachte Fokussiergas durch den Hohlraum 16 geleitet. Durch die hier gewählte Hohlraumgeometrie wird das Fokussiergas dabei derart in Richtung Materialstrom gelenkt, dass dieser umfangseitig angeströmt und im weiteren Verlauf vom Fokussiergas im Wesentlichen ringförmig ummantelt wird. Dadurch kann unter anderem der Querschnitt des Strahls aus ausgestoßenem leitfähigem Material beeinflusst werden. Als Übergang zwischen den zusätzlichen Zuführungen 3 und dem Hohlraum 16 ist eine ringförmige Verteilernut 21 vorgesehen. Hier verteilt sich das über die zusätzlichen Zuführungen 3 eingeleitete Fokussiergas gleichmäßig auf den gesamten Umfang, bevor es dann in den sich direkt daran anschließenden Hohlraum 16 strömt und in Richtung Materialstrom gelenkt wird.

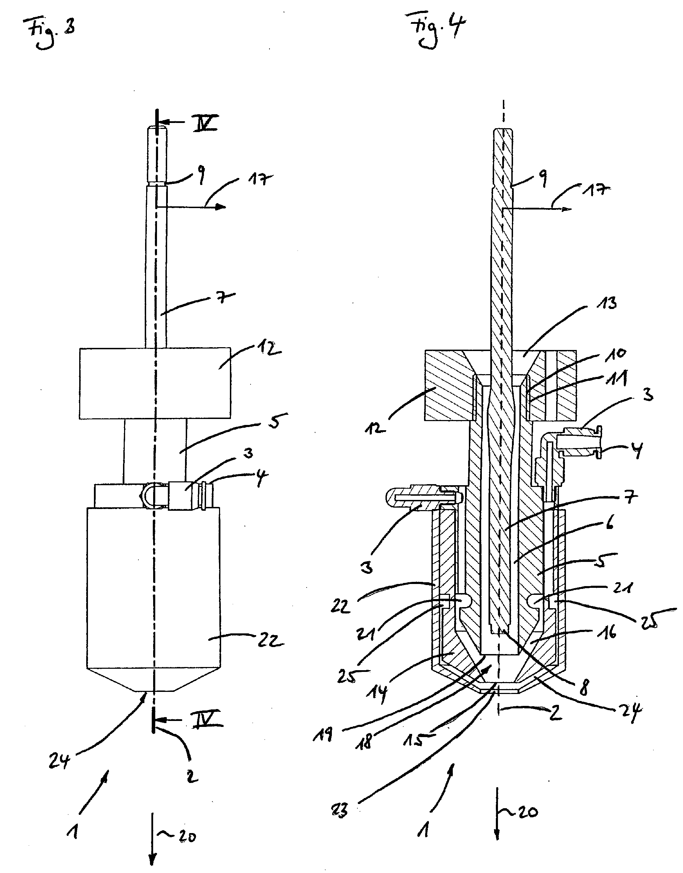

Eine alternative Ausführung eines erfindungsgemäßen Düsenkopfes 1 ist in Fig. 3 in einer Seitenansicht und in Fig. 4 in einer Schnittdarstellung entlang der Mittellängsachse 2 abgebildet. Der Düsenkopfes 1 aus dem ersten Ausführungsbeispiel dient hierbei als Basis für den Aufbau des alternativen Düsenkopfes 1. Über die Kappe 14 ist bei der alternativen Düsenkopfvariante ergänzend eine zweite Kappe 22 mit einer zweiten Düsenblende 23 gestülpt. Zwischen der zweiten Kappe 22 und der Kappe 14 verbleibt wiederum ein zweiter ringförmiger Zwischenraum, nachfolgend als zweiter Hohlraum 24 bezeichnet, durch den ein zweites Fokussiergas, welches über eine separate zusätzliche Zuführung 3 in den Düsenkopf 1 eingeleitet wird, in Richtung Materialstrom gelenkt wird. Der zweite Hohlraum 24 ist analog zum ersten Hohlraum 16 im Querschnitt ringförmig. In radialer Richtung 17 wird auch dieser Hohlraum 24 durch die Mantelflächen zweier gerader Kreiskegelstümpfe mit unterschiedlichen Volumina begrenzt. Die beiden Kreiskegelstümpfe weisen wieder einen gleich großen Öffnungswinkel auf und deren Basiskreise sind konzentrisch angeordnet. Somit wird der Gasstrahl des ersten Fokussiergases im Betrieb umfangseitig mit dem zweiten Fokussiergas angeströmt und das zweite Fokussiergas ummantelt das erste Fokussiergas im weiteren Verlauf im Wesentlichen ringförmig. Zwischen die zusätzliche Zuführung 3 für das zweite Fokussiergas und den zweiten Hohlraum 24 ist zudem eine zweite Verteilernut 25 zwischengeschaltet, so dass sich das zweite Fokussiergas umfangseitig verteilen kann, bevor dieses dann in den Hohlraum 24 einströmt. Aufgrund der gegebenen Hohlraumgeometrie wird das zweite Fokussiergas dort in Richtung Materialstrom gelenkt, wodurch zum Beispiel der Querschnitt des Strahls aus ausgestoßenem leitfähigem Material zusätzlich und damit noch genauer beeinflusst werden kann.

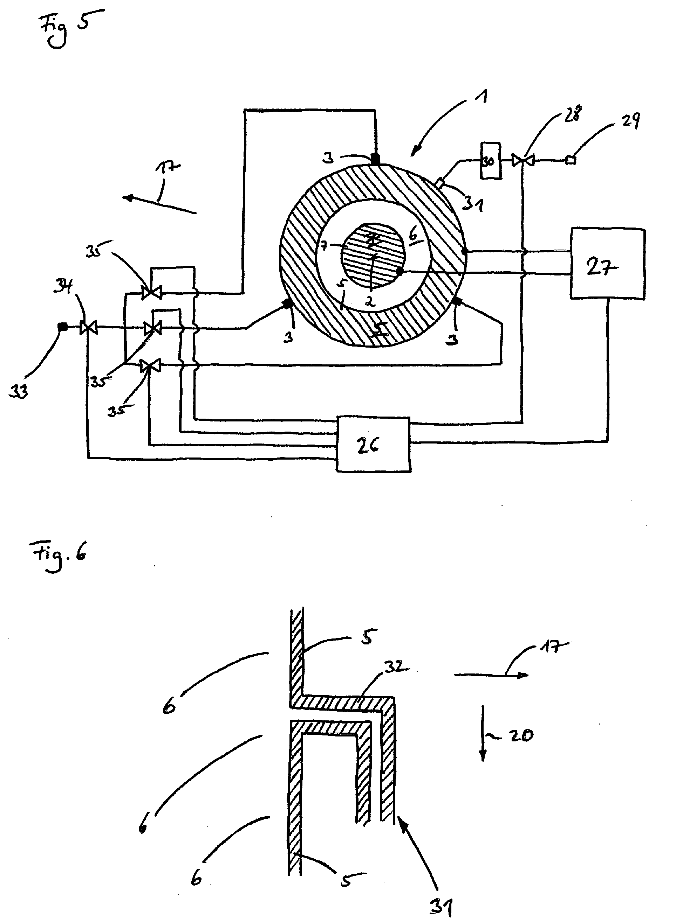

Zur Steuerung der erfindungsgemäßen Vorrichtung ist weiter eine Steuerungseinheit 26 vorgesehen. Mit Hilfe dieser Steuerungseinheit 26 kann im Betrieb zwischen den Elektroden 5,7 eine Potentialdifferenz vorgegeben werden. In der exemplarisch angeführten schematischen Darstellung eines Düsenkopfes 1 mit einer Kappe 14 aus Fig. 5 ist die Steuerungseinheit 26 hierfür regelungstechnisch mit einer Spannungsquelle 27 verbunden. Über die Steuerungseinheit 26 wird zudem die Einspeisung des Gemisches aus Trägergas und leitfähigem, pulverförmigem Material für den Aufspritzprozess in den Düsenkopf 1 manipuliert. Dazu wird über ein Regelventil 28 der Volumenstrom des aus einer Quelle 29 stammenden Trägergases eingestellt. Jener Volumenstrom durchquert eine Dosiervorrichtung 30, in der dieser zur Erzeugung des Gemisches mit leitfähigem Material gezielt angereichert wird. Das so gebildete Gemisch strömt anschließend über eine Quellmaterialzuführung, nachfolgend kurz Zuführung 31 genannt, in den Strömungskanal 6.

Entsprechend einer Variante der erfindungsgemäßen Vorrichtung ist in die Zuführung 31 ein Umlenkelement 32 integriert. Fig. 6 zeigt ein Beispiel, bei der sich die Zuführung 31 nach Art einer Stichleitung in radialer Richtung 17 an den Strömungskanal anschließt und das Umlenkelement 32 durch ein abgewinkeltes Teilstück der Zuführung 31 gegeben ist. Der hierdurch erzwungene abrupte Richtungswechsel bedingt lokale Verwirbelungen im Trägergas, was in der Folge zu einer Durchmischung und damit zu einer Homogenisierung des Gemisches führt.

Im Strömungskanal 6 wird das Trägergas aufgrund der zwischen den Elektroden 5,7 anliegenden Spannung ionisiert und das vom Trägergas mitgeführte leitfähige Pulver teilweise verflüssigt. Dieser Materialstrom aus ionisiertem Trägergas und teilweise verflüssigtem leitfähigem Material wird als Strahl aus dem Düsenaustritt ausgeworfen und trifft schließlich auf das davor platzierte Substrat bzw. Bauteil, auf dessen Oberfläche das leitfähige Material wie vorgesehen anhaftet. Zur Variation insbesondere des Querschnitts des Strahls aus ausgestoßenem leitfähigem Material wird der Materialstrom im Bereich des Düsenaustritts mit dem Fokussiergas umfangseitig angeströmt. Dieses wird aus einem Reservoir 33 in die erfindungsgemäße Vorrichtung eingespeist. Im Ausführungsbeispiel gelangt das Fokussiergas über ein von der Steuerungseinheit 26 angesteuertes Systemventil 34 zunächst in ein Verteilernetz und von dort über drei unabhängig voneinander ansteuerbare Funktionsventile 35 in die zusätzlichen Zuführungen 3.

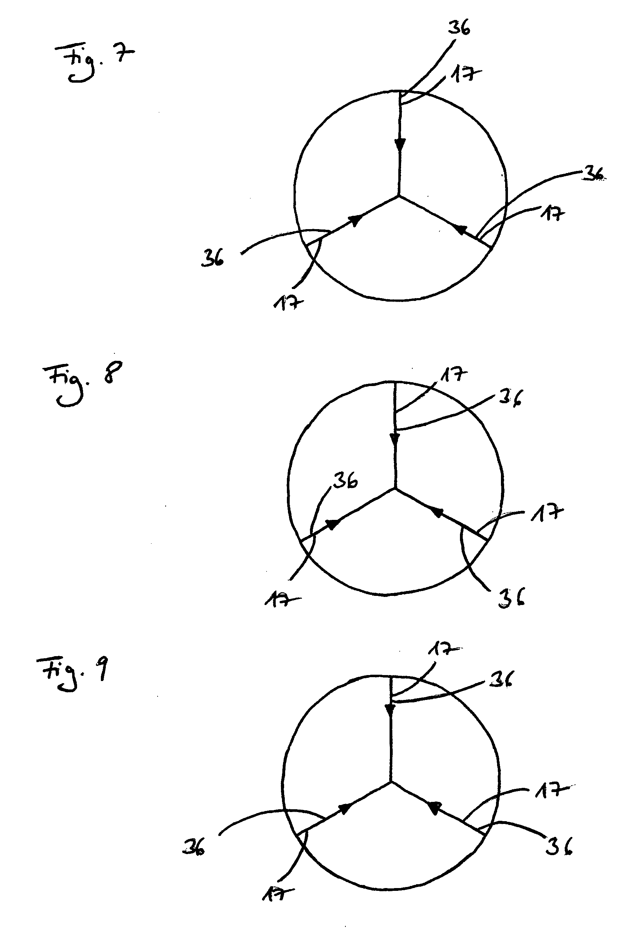

Durch die in dieser Ausführung der erfindungsgemäßen Vorrichtung realisierte Entkoppelung der Fokussiergasströme in die drei zusätzlichen Zuführungen 3 kann der Volumenstrom durch den Hohlraum 16 gezielt zeit- und winkelabhängig, also in Abhängigkeit des mit der Drehsymmetrie des Düsenkopfes 1 verknüpften Drehwinkels, gestaltet werden. Eine beispielhafte Gestaltung des Volumenstromes ist in Fig. 7 bis Fig. 9 angedeutet. Hier werden die Fokussiergasströme in die drei zusätzlichen Zuführungen 3 durch Vektoren 36 repräsentiert. Zum Zeitpunkt 1, dargestellt in Fig. 7, ist der auf der rechten Seite abgebildete Fokussiergasstrom vom Betrag her gegenüber den beiden übrigen Fokussiergasströmen reduziert. Analog ist der linke Fokussiergasstrom zum Zeitpunkt 2, dargestellt in Fig. 8, um den gleichen Betrag reduziert. Zum Zeitpunkt 3 schließlich, dargestellt in Fig. 9, ist der oben abgebildete Fokussiergasstrom reduziert. Zwischen den drei Zeitpunkten 1 bis 3 sind kontinuierliche Übergänge vorgesehen.

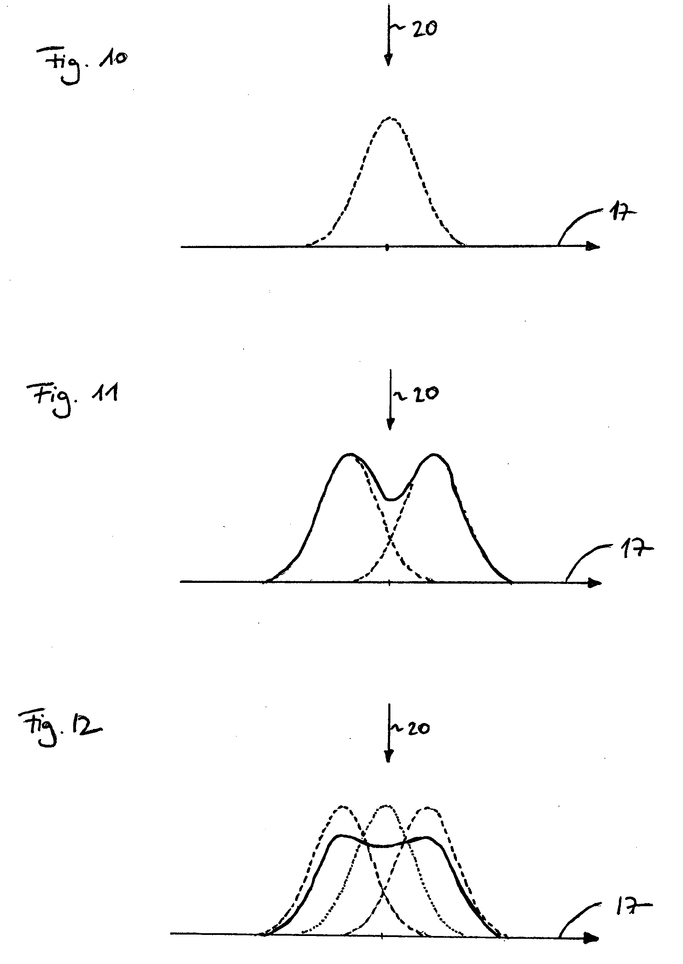

Mit Hilfe einer derartigen dynamischen Betriebsweise des Volumenstroms des Fokussiergases ist es unter anderem möglich, die Ortsabhängigkeit der Schichtdicke der aufgespritzten Strukturen zu beeinflussen. Im stationären Betrieb, bei dem der Volumenstrom des Fokussiergases zeit- und winkelunabhängig ist, und ohne Relativbewegung zwischen Düsenkopf 1 und Substrat bzw. Bauteil, bildet sich auf der Oberfläche des Substrates bzw. des Bauteiles ein ansatzweise scheibenförmiges Spritzmuster aus. Das Schichtdickenprofil dieser scheibenförmigen Materialanlagerung kann dabei näherungsweise durch eine Glockenkurve, wie sie in Fig. 10 dargestellt ist, beschrieben werden. Im dynamischen Betrieb wird durch Variation der einzelnen Fokussiergasströme in die zusätzlichen Zuführungen 3 eine Verkippung des Strahls aus ausgestoßenem leitfähigem Material gegen die Mittellängsache 2 erreicht. Bewegt sich dieser Strahl beispielweise zwischen zwei Auslenkpunkten hin und her, so kann hierdurch ein Spritzmuster mit einem entlang der Verbindungslinie zwischen den zwei Auslenkpunkten ansatzweise rechteckigen Schichtdickenprofil, wie es in Fig.12 abgebildet ist, erzwungen werden. Die Strukturen aus leitfähigem Material, die mit der erfindungsgemäßen Vorrichtung aufgespritzt werden, sind bei Ausnutzung einer derartigen dynamischen Betriebsweise somit wesentlich gleichmäßiger bezüglich ihrer Schichtdicken und, relativ gesehen, schärfer bezüglich ihrer Abgrenzungen in den Randbereichen.

## Patentansprüche

1. Vorrichtung zum Aufspritzen einer Struktur aus leitfähigem Material auf ein Substrat oder Bauteil mit Hilfe eines Plasmaverfahrens umfassend eine Zuführung (31) für das leitfähige Material und für ein Trägergas und umfassend einen Düsenkopf (1)
- mit einer äußeren Elektrode (5), die einen zentralen Strömungskanal (6) mit einer endseitigen Austrittsöffnung (19) aufweist,
- mit einer inneren Elektrode (7), welche im Strömungskanal (6) positioniert ist und ein Freiende (8) aufweist,
- und mit einer Düsenblende (15),
wobei weiterhin eine Steuerungseinheit (26) zur Steuerung vorgesehen ist, derart, dass im Betrieb zwischen den beiden Elektroden (5,7) eine elektrische Spannung anliegt, aufgrund derer das den Strömungskanal (6) in Strömungsrichtung (20) durchströmende Trägergas ionisiert wird, so dass das über die Zuführung (31) in den Strömungskanal (6) eingebrachte leitfähige Material zumindest teilweise verflüssigt wird,
**dadurch gekennzeichnet,**
- **dass** im Bereich der Austrittsöffnung (19) eine zusätzliche Zuführung (3) für ein Fokussiergas vorgesehen ist, derart, dass sich im Betrieb an der Austrittsöffnung (19) ein Fokussiergas-Strömungsring um das ionisierte Trägergas samt dem teilweise verflüssigten Material ausbildet,
- **dass** das Fokussiergas über mehrere zusätzliche Zuführungen (3) eingeleitet wird, die um den Düsenkopf (1) herum angeordnet sind, und
- **dass** die Steuerungseinheit (26) zudem derart ausgebildet ist, dass die Einleitung des Fokussiergases in eine jede zusätzliche Zuführung (3) derart regulierbar ist, dass der Volumenstrom des Fokussiergases durch eine jede zusätzliche Zuführung (3) zeitabhängig variiert wird,
• wobei jeder Volumenstrom proportional zu einer vorgegebenen zeitperiodischen Funktion variiert wird,
• wobei für alle Volumenströme genau eine zeitperiodische Funktion vorgesehen ist und
• wobei für jeden Volumenstrom eine konstante Phase vorgesehen ist.

2. Vorrichtung nach Anspruch 1,
**dadurch gekennzeichnet,**
**dass** der Düsenkopf (1) eine trichterförmige Kappe (14) aufweist, in die die äußere Elektrode (5) samt Strömungskanal (6) mittig hineinragt, wobei zwischen der Kappe (14) und der äußeren Elektrode (5) im Bereich der Austrittsöffnung (19) ein Zwischenraum (16) mit ringförmigem Querschnitt ausgebildet ist, in den die zusätzlichen Zuführungen (3) für das Fokussiergas münden, so dass das Fokussiergas den Zwischenraum im Betrieb durchströmt und dabei derart gelenkt wird, dass sich der Fokussiergas-Strömungsring ausbildet.

3. Vorrichtung nach Anspruch 2,
**dadurch gekennzeichnet,**
**dass** der Zwischenraum (16) senkrecht zur Strömungsrichtung (20) durch die Mantelflächen zweier gerader Kreiskegelstümpfe begrenzt ist.

4. Vorrichtung nach Anspruch 2,
**dadurch gekennzeichnet,**
**dass** zwischen den zusätzlichen Zuführungen (3) für das Fokussiergas und dem Zwischenraum (16) eine ringförmige Verteilernut (21) positioniert ist.

5. Vorrichtung nach einem der Ansprüche 1 bis 4,
**dadurch gekennzeichnet,**
**dass**, bezogen auf die Strömungsrichtung (20), die Austrittsöffnung (19) der Düsenblende (15) vorgelagert ist.

6. Vorrichtung nach einem der Ansprüche 1 bis 5,
**dadurch gekennzeichnet,**
**dass**, bezogen auf die Strömungsrichtung (20), das Freiende (8) der inneren Elektrode (7) der Austrittsöffnung (19) vorgelagert ist.

7. Vorrichtung nach einem der Ansprüche 4 bis 6,
**dadurch gekennzeichnet,**
**dass**, bezogen auf die Strömungsrichtung (20), die Verteilernut (21) dem Freiende (8) der inneren Elektrode (7) vorgelagert ist.

8. Vorrichtung nach einem der Ansprüche 1 bis 7,
**dadurch gekennzeichnet,**
**dass** eine zusätzliche Zuführung (3) für ein zweites Fokussiergas im Bereich der Austrittsöffnung (19) vorgesehen ist, derart dass sich im Betrieb ein zweiter Fokussiergas-Strömungsring ausbildet, der den ersten näherungsweise konzentrisch umgibt.

9. Vorrichtung nach Anspruch 8,
**dadurch gekennzeichnet,**
**dass** der Düsenkopf (1) eine zweite trichterförmige Kappe (22) aufweist, in die die erste Kappe (14) samt der äußeren Elektrode (5) und dem Strömungskanal (6) mittig hineinragt, wobei zwischen der zweiten Kappe (22) und der ersten Kappe (14) im Bereich der Austrittsöffnung (19) ein zweiter Zwischenraum (24) mit ringförmigem Querschnitt ausgebildet ist, in den die zusätzliche Zuführung (3) für das zweite Fokussiergas mündet, so dass das zweite Fokussiergas den zweiten Zwischenraum (24) im Betrieb durchströmt und dabei derart gelenkt wird, dass sich der zweite Fokussiergas-Strömungsring ausbildet.

10. Vorrichtung nach einem der Ansprüche 1 bis 9,
**dadurch gekennzeichnet,**
**dass** in der Zuführung (31) des Trägergases und des leitfähigen Materials mindestens ein Umlenkelement (32) vorgesehen ist, an dem das Trägergas samt dem leitfähigen Material eine sprunghafte Richtungsänderung, insbesondere eine Richtungsumkehrung, erfährt.

11. Vorrichtung nach einem der Ansprüche 1 bis 10,
**dadurch gekennzeichnet,**
**dass** die Steuerungseinheit (26) derart ausgebildet ist, dass die Einleitung des Fokussiergases in eine jede zusätzliche Zuführung (3) derart reguliert wird, dass dadurch der aus der Düsenblende (15) austretende Materialstrom und insbesondere dessen Strahlquerschnitt einstellbar sind.

12. Verfahren zum Aufspritzen einer Struktur aus leitfähigem Material auf ein Substrat oder Bauteil mit Hilfe eines Plasmaverfahrens mit einer Vorrichtung insbesondere nach einem der vorhergehenden Ansprüche umfassend eine Zuführung (31) für das leitfähige Material und für ein Trägergas und umfassend einen Düsenkopf (1)
- mit einer äußeren Elektrode (5), die einen zentralen Strömungskanal (6) mit einer endseitigen Austrittsöffnung (19) aufweist,
- mit einer inneren Elektrode (7), welche im Strömungskanal (6) positioniert ist und ein Freiende (8) aufweist,
- und mit einer Düsenblende (15),
wobei zwischen den beiden Elektroden (5,7) eine elektrische Spannung angelegt wird, aufgrund derer das den Strömungskanal (6) in Strömungsrichtung (20) durchströmende Trägergas ionisiert wird, so dass das über die Zuführung (31) in den Strömungskanal (6) eingebrachte leitfähige Material zumindest teilweise verflüssigt wird,
**dadurch gekennzeichnet,**
- **dass** im Bereich der Austrittsöffnung (19) ein Fokussiergas zugeführt wird, derart, dass sich an der Austrittsöffnung (19) ein Fokussiergas-Strömungsring um das ionisierte Trägergas samt dem teilweise verflüssigten Material ausbildet,
- **dass** das Fokussiergas über mehrere zusätzliche Zuführungen (3) eingeleitet wird, die um den Düsenkopf (1) herum angeordnet sind, und
- **dass** die Einleitung des Fokussiergases in eine jede zusätzliche Zuführung (3) derart reguliert wird, dass der Volumenstrom des Fokussiergases durch eine jede zusätzliche Zuführung (3) zeitabhängig variiert wird,
• wobei jeder Volumenstrom proportional zu einer vorgegebenen zeitperiodischen Funktion variiert wird,
• wobei für alle Volumenströme genau eine zeitperiodische Funktion vorgesehen ist und
• wobei für jeden Volumenstrom eine konstante Phase vorgesehen ist.

## Claims

1. Device for spraying a structure of conductive material onto a substrate or component with the aid of a plasma process, comprising a feed (31) for the conductive material and for a carrier gas and comprising a nozzle head (1)
- with an outer electrode (5), which has a central flow channel (6) with an outlet opening (19) at the end,
- with an inner electrode (7), which is positioned in the flow channel (6) and has a free end (8),
- and with a nozzle orifice plate (15),
wherein a control unit (26) is also provided for control purposes, in such a way that during operation there is an electrical voltage between the two electrodes (5, 7), on the basis of which the carrier gas flowing through the flow channel (6) in the direction of flow (20) is ionized, so that the conductive material introduced into the flow channel (6) by way of the feed (31) is at least partially liquefied,
**characterized**
- **in that** an additional feed (3) for a focussing gas is provided in the region of the outlet opening (19) in such a way that during operation a ring of flowing focussing gas forms around the ionized carrier gas, together with the partially liquefied material, at the outlet opening (19),
- **in that** the focussing gas is introduced by way of a number of additional feeds (3), which are arranged around the nozzle head (1), and
- **in that** the control unit (26) is also formed in such a way that the introduction of the focussing gas into each and every additional feed (3) can be regulated in such a way that the volume flow of the focussing gas through each, and every additional feed (3) is varied in a time-dependent manner,
• each volume flow being varied in proportion to a predetermined time-periodic function,
• just one time-periodic function being provided for all the volume flows and
• a constant phase being provided for each volume flow.

2. Device according to Claim 1, **characterized in that** the nozzle head (1) has a funnel-shaped cap (14), into which the outer electrode (5) together with the flow channel (6) centrally protrudes, an intermediate space (16) with an annular cross section into which the additional feeds (3) for the focussing gas open out being formed between the cap (14) and the outer electrode (5) in the region of the outlet opening (19), so that during operation the focussing gas flows through the intermediate space and is thereby directed in such a way that the ring of flowing focussing gas forms.

3. Device according to Claim 2, **characterized in that** the intermediate space (16) is bounded perpendicularly in relation to the direction of flow (20) by the lateral surfaces of two frustums of a straight circular cone.

4. Device according to Claim 2, **characterized in that** an annular distributing groove (21) is positioned between the additional feeds (3) for the focussing gas and the intermediate space (16).

5. Device according to one of Claims 1 to 4, **characterized in that**, with respect to the direction of flow (20), the outlet opening (19) is arranged ahead of the nozzle orifice plate (15).

6. Device according to one of Claims 1 to 5, **characterized in that**, with respect to the direction of flow (20), the free end (8) of the inner electrode (7) is arranged ahead of the outlet opening (19).

7. Device according to one of Claims 4 to 6, **characterized in that**, with respect to the direction of flow (20), the distributing groove (21) is arranged ahead of the free end (8) of the inner electrode (7).

8. Device according to one of Claims 1 to 7, **characterized in that** an additional feed (3) for a second focussing gas is provided in the region of the outlet opening (19) in such a way that a second ring of flowing focussing gas that surrounds the first almost concentrically forms during operation.

9. Device according to Claim 8, **characterized in that** the nozzle head (1) has a second funnel-shaped cap (22), into which the first cap (14) together with the outer electrode (5) and the flow channel (6) centrally protrudes, a second intermediate space (24) with an annular cross section into which the additional feed (3) for the second focussing gas opens out being formed between the second cap (22) and the first cap (14) in the region of the outlet opening (19), so that the second focussing gas flows through the second intermediate space (24) during operation and is thereby directed in such a way that the second ring of flowing focussing gas forms.

10. Device according to one of Claims 1 to 9, **characterized in that** at least one deflecting element (32), at which the carrier gas together with the conductive material undergoes an abrupt change in direction, in particular a reversal of direction, is provided in the feed (31) of the carrier gas and the conductive material.

11. Device according to one of Claims 1 to 10, **characterized in that** the control unit (26) is formed in such a way that the introduction of the focussing gas into each and every additional feed (3) is regulated in such a way that the stream of material emerging from the nozzle orifice plate (15), and in particular the cross section of the jet of this material, can thereby be set.

12. Method for spraying a structure of conductive material onto a substrate or component with the aid of a plasma process by a device, in particular according to one of the preceding claims, comprising a feed (31) for the conductive material and for a carrier gas and comprising a nozzle head (1)
- with an outer electrode (5), which has a central flow channel (6) with an outlet opening (19) at the end,
- with an inner electrode (7), which is positioned in the flow channel (6) and has a free end (8),
- and with a nozzle orifice plate (15),
an electrical voltage being applied between the two electrodes (5, 7), on the basis of which the carrier gas flowing through the flow channel (6) in the direction of flow (20) is ionized, so that the conductive material introduced into the flow channel (6) by way of the feed (31) is at least partially liquefied,
**characterized**
- **in that** in the region of the outlet opening (19) a focussing gas is fed in such a way that a ring of flowing focussing gas forms around the ionized carrier gas, together with the partially liquefied material, at the outlet opening (19),
- **in that** the focussing gas is introduced by way of a number of additional feeds (3), which are arranged around the nozzle head (1), and
- **in that** the introduction of the focussing gas into each and every additional feed (3) is regulated in such a way that the volume flow of the focussing gas through each and every additional feed (3) is varied in a time-dependent manner,
• each volume flow being varied in proportion to a predetermined time-periodic function,
• just one time-periodic function being provided for all the volume flows and
• a constant phase being provided for each volume flow.

## Revendications

1. Dispositif de projection d'une structure en matériau conducteur sur un substrat ou un composant à l'aide d'un procédé à plasma, le dispositif présentant une amenée (31) de matériau conducteur et de gaz porteur et comportant une tête de tuyère (1) qui présente
- une électrode extérieure (5) dotée d'un canal central d'écoulement (6) avec une ouverture terminale de sortie (19),
- une électrode intérieure (7) placée dans le canal d'écoulement (6) et présentant une extrémité libre (8) et
- un écran de tuyère (15),
une unité de commande (26) étant en outre prévue pour la commande de telle sorte qu'en fonctionnement une tension électrique soit appliquée entre les deux électrodes (5, 7) et ionisant le gaz porteur qui traverse le canal d'écoulement (6) dans une direction d'écoulement (20) de telle sorte que le matériau conducteur amené dans le canal d'écoulement (6) par l'amenée (31) soit liquéfié au moins en partie,
**caractérisé en ce que**
- une amenée supplémentaire (3) est prévue au niveau de l'ouverture de sortie (19) pour un gaz de focalisation de telle sorte qu'en fonctionnement un anneau d'écoulement de gaz de focalisation se forme à l'ouverture de sortie (19) autour du gaz porteur ionisé et du matériau partiellement liquéfié,
- **en ce que** le gaz de focalisation est introduit par plusieurs amenées supplémentaires (3) disposées autour de la tête (1) de la tuyère,
- **en ce que** l'unité de commande (26) est de plus configurée de manière à pouvoir réguler l'introduction de gaz de focalisation dans chaque amenée supplémentaire (3) de telle sorte que le débit volumique de gaz de focalisation soit modifié en fonction du temps dans chaque amenée supplémentaire (3),
• **en ce que** chaque débit volumique est modifié de manière proportionnelle à une fonction périodique prédéterminée,
• **en ce qu'**une unique fonction périodique est prévue pour chacun des débits volumiques et
• **en ce qu'**une phase constante est prévue pour chaque débit volumique.

2. Dispositif selon la revendication 1,
**caractérisé en ce que**
la tête (1) de la tuyère présente un capot (14) en forme d'entonnoir au centre duquel l'électrode extérieure (5) pénètre en même temps que le canal d'écoulement (6), un espace intermédiaire (16) de section transversale annulaire étant formé entre le capot (14) et l'électrode extérieure (5) au niveau de l'ouverture de sortie (19) et les amenées supplémentaires (3) de gaz de focalisation y débouchant de telle sorte qu'en fonctionnement, le gaz de focalisation traverse l'espace intermédiaire et soit guidé de manière à former l'anneau d'écoulement de gaz de focalisation.

3. Dispositif selon la revendication 2,
**caractérisé en ce que**
l'espace intermédiaire (16) est délimité perpendiculairement à la direction d'écoulement (20) par la surface d'enveloppe de deux troncs de cônes circulaires droits.

4. Dispositif selon la revendication 2,
**caractérisé en ce qu'**une
rainure annulaire de répartition (21) est disposée entre les amenées supplémentaires (3) de gaz de focalisation et l'espace intermédiaire (16).

5. Dispositif selon l'une des revendications 1 à 4,
**caractérisé en ce que**
l'ouverture de sortie (19) est disposée en amont de l'écran (15) de tuyère dans la direction d'écoulement (20).

6. Dispositif selon l'une des revendications 1 à 5,
**caractérisé en ce que**
l'extrémité libre (8) de l'électrode intérieure (7) est disposée en amont de l'ouverture de sortie (19) dans la direction d'écoulement (20).

7. Dispositif selon l'une des revendications 4 à 6,
**caractérisé en ce que**
la rainure de répartition (21) est disposée en amont de l'extrémité libre (8) de l'électrode intérieure (7) dans la direction d'écoulement (20).

8. Dispositif selon l'une des revendications 1 à 7,
**caractérisé en ce qu'**une
amenée supplémentaire (3) pour un deuxième gaz de focalisation est prévue au niveau de l'ouverture de sortie (19) de telle sorte qu'en fonctionnement, il se forme un deuxième anneau d'écoulement de gaz de focalisation qui entoure le premier de manière approximativement concentrique.

9. Dispositif selon la revendication 8,
**caractérisé en ce que**
la tête (1) de la tuyère présente un deuxième capot (22) en forme d'entonnoir au centre duquel s'enfonce le premier capot (14) en même temps que l'électrode extérieure (5) et que le canal d'écoulement (6), un deuxième espace intermédiaire (24) de section transversale annulaire étant formé entre le deuxième capot (22) et le premier capot (14) au niveau de l'ouverture de sortie (19), l'amenée supplémentaire (3) du deuxième gaz de focalisation débouchant dans cet espace intermédiaire de telle sorte que le deuxième gaz de focalisation traverse le deuxième espace intermédiaire (24) en fonctionnement et soit guidé de manière à ce qu'un deuxième anneau d'écoulement de gaz de focalisation se forme.

10. Dispositif selon l'une des revendications 1 à 9,
**caractérisé en ce qu'**au
moins un élément de guidage (32) sur lequel le gaz porteur ainsi que le matériau conducteur subissent une modification brusque de direction, en particulier une inversion de direction, est prévu dans l'amenée (31) de gaz porteur et de matériau conducteur.

11. Dispositif selon l'une des revendications 1 à 10,
**caractérisé en ce que**
l'unité de commande (26) est configurée de manière à réguler l'amenée de gaz de focalisation dans chaque amenée supplémentaire (3) de telle sorte que l'écoulement de matière qui sort de l'écran (15) de la tuyère et en particulier la section transversale de son jet puissent être régulés.

12. Procédé de projection d'une structure en matériau conducteur sur un substrat ou un composant à l'aide d'un procédé à plasma, avec un dispositif présentant une amenée (31) de matériau conducteur et de gaz porteur et comportant une tête de tuyère (1) qui présente
- une électrode extérieure (5) dotée d'un canal central d'écoulement (6) avec une ouverture terminale de sortie (19),
- une électrode intérieure (7) placée dans le canal d'écoulement (6) et présentant une extrémité libre (8) et
- un écran de tuyère (15),
une tension électrique étant appliquée entre les deux électrodes (5, 7) et ionisant le gaz porteur qui traverse le canal d'écoulement (6) dans une direction d'écoulement (20) de telle sorte que le matériau conducteur amené dans le canal d'écoulement (6) par l'amenée (31) soit liquéfié au moins en partie,
**caractérisé en ce que**
- pour un gaz de focalisation est apporté au niveau de l'ouverture de sortie (19) de telle sorte qu'en fonctionnement un anneau d'écoulement de gaz de focalisation se forme à l'ouverture de sortie (19) autour du gaz porteur ionisé et du matériau partiellement liquéfié,
- **en ce que** le gaz de focalisation est introduit par plusieurs amenées supplémentaires (3) disposées autour de la tête (1) de la tuyère,
- **en ce que** l'introduction de gaz de focalisation dans chaque amenée supplémentaire (3) est régulée de telle sorte que le débit volumique de gaz de focalisation soit modifié en fonction du temps dans chaque amenée supplémentaire (3),
• **en ce que** chaque débit volumique est modifié de manière proportionnelle à une fonction périodique prédéterminée,
• **en ce qu'**une unique fonction périodique est prévue pour chacun des débits volumiques et
• **en ce qu'**une phase constante est prévue pour chaque débit volumique.
